Europäisches Patentamt

European Patent Office

Office européen des brevets

(19)

(11) EP 0 777 279 A2

(12) EUROPÄISCHE PATENTANMELDUNG

(43) Veröffentlichungstag:
04.06.1997 Patentblatt 1997/23

(51) Int. Cl.6: H01L 51/20

(21) Anmeldenummer: 96117833.2

(22) Anmeldetag: 07.11.1996

(84) Benannte Vertragsstaaten:
BE CH DE FI FR GB IT LI NL SE

(30) Priorität: 20.11.1995 DE 19543205

(71) Anmelder: BAYER AG
51368 Leverkusen (DE)

(72) Erfinder:
• Elschner, Andreas, Dr.
  45479 Mülheim/Ruhr (DE)
• Wehrmann, Rolf, Dr.
  47800 Krefeld (DE)
• Bütje, Kai, Dr.
  47229 Duisburg (DE)

(54) Zwischenschicht in elektrolumineszierenden Anordnungen enthaltend feinteilige anorganische Partikel

(57) Die vorliegende Erfindung betrifft Zwischenschichten aus anorganischen Materialien in elektrolumineszierenden Anordnungen, die feinteilige anorganische Partikel (Nanoteilchen), die in einem polymeren Binder dispergiert sind, enthalten.

EP 0 777 279 A2

**Beschreibung**

Die vorliegende Erfindung betrifft Zwischenschichten aus anorganischen Materialien in elektrolumineszierenden Anordnungen, die feinteilige anorganische Partikel (Nanoteilchen), die in einem polymeren Binder dispergiert sind, enthalten.

Strombetriebene lichtemittierende Anordnungen haben in unserem optoelektronischen Zeitalter eine große Bedeutung. Die Entwicklung der optischen Anzeigeelemente zielt auf Anordnungen, die flach sind, großflächig betrieben werden können, eine hohe Effizienz besitzen und niedrig in den Herstellungskosten sind. Es gibt eine Anzahl von unterschiedlichen Möglichkeiten, elektrisch betriebene lichtemittierende Anordnungen herzustellen. Es sind aber nur zwei Systemklassen bekannt, die die Anforderungen großflächig, flach und preisgünstige Herstellung in sich vereinen.

1.) Dotierte ZnS-Partikel in Bindermatrix

Die ZnS-Partikel werden in eine dünne Schicht eingearbeitet und lumineszieren beim Anlegen eines hochfrequenten elektrischen Feldes. Die Leuchtdichte der ZnS-Systeme ist niedrig. Ein weiterer Nachteil ist die notwendige hohe Betriebsspannung bei hoher Frequenz.

2.) Elektrolumineszierende Polymere

Polymere Leuchtdioden auf Basis von Poly-(Phenylen-Vinylen) wurden erstmalig von Friend et al. (US-P-5 247 190) beschrieben. Im einfachsten Aufbau wird das Polymer zwischen eine transparente Anode (z.B.: ITO) und eine aufgedampfte Kathode (z.B.: Ca, Al) gebracht. Die Anordnung emittiert beim Anlegen einer Spannung Licht.

Der allgemeinste Fall für den Schichtaufbau in einer organischen LED ist in EP-A-0 637 899 angegeben. Dort werden auch zusätzliche Schichten beschrieben, die einen positiven Einfluß auf die Funktion der lichtemittierenden Anordnungen haben. Die Eigenschaften aus organischen Komponenten aufgebauter LEDs lassen sich durch das Einfügen von zusätzlichen organischen Schichten deutlich verbessern (Tang et al., Appl. Phys. Lett. 51 (1987) 913). Dazu wird zwischen die elektrolumineszierende Schicht und die beiden Elektroden eine oder zwei ladungsinjizierende Schichten eingefügt. Diese kann aus aufgedampften Monomeren (Adachi et al., Appl. Phys. Lett. 57 (1990) 531), Polymeren (US-P-5 231 329) oder aus Monomeren, dispergiert in Polymeren (Brown et al., Appl. Phys. Lett. 61 (1992) 2739), bestehen. Es handelt sich dabei z.B. um Oxadiazole oder tertiäre Amine. Auch Polymere mit Oxadiazolstrukturen wurden beschrieben. Es handelt sich dabei immer um organische Moleküle.

Die Erfindung betrifft Zwischenschichten, enthaltend feinteilige anorganische Partikel (Nanoteilchen), die in einem polymeren Binder dispergiert sind, in lichtemittierenden Anordnungen bzw. Dioden (LED) sowie die Verwendung der Nanoteilchen zur Herstellung von Zwischenschichten in LEDs und lichtemittierenden (elektrolumineszierenden) Anordnungen, enthaltend eine oder mehrerer dieser Zwischenschichten.

Die Nanoteilchen haben im allgemeinen einen Durchmesser $<1\ \mu m$, vorzugsweise 1-100 nm. Die Größe der Teilchen wird mit hochauflösender Transmissions-Elektronen-Mikroskopie oder Ultrazentrifugation bestimmt. Sie bestehen bevorzugt aus halbleitendem Material, wobei der Bandabstand, d.h. der Energieunterschied zwischen der Valenzbandoberkante und der Leitungsbandunterkante mindestens 1 eV betragen sollte. Als feinteilige anorganische (nanodisperse) Partikel sind z.B. Metalloxide wie $TiO_2$, $SnO_2$, ZnO, $WO_3$, $Al_2O_3$, $Fe_2O_3$ oder Halbleiterverbindungen aus der III. und V. Hauptgruppe des Periodensystems (III-V-Halbleiter) wie z.B. GaP, AlN oder Halbleiterverbindungen aus der II. und VI. Hauptgruppe des Periodensystems (II-VI-Halbleiter) wie z.B. ZnSe, CdSe, CdS geeignet (Periodensystem nach Mendelejew).

Besonders bevorzugt sind Nanoteilchen aus Titandioxid.

Der Gewichtsanteil der Nanoteilchen im polymeren Binder liegt zwischen 0,1 und 90 Gew.-%, vorzugsweise zwischen 1 und 70 Gew.-% und besonders bevorzugt zwischen 5 und 60 Gew.-% (bezogen auf das Gewicht der Zwischenschicht).

Die Nanoteilchen werden zur späteren Schichtherstellung in polymeren Bindern dispergiert. Als Binder sind vorzugsweise amorphe Polymere, die sich zu transparenten Filmen verarbeiten lassen, geeignet. Dies sind beispielsweise Polycarbonate, Polystyrol und Copolymere des Polystyrols wie SAN, cyclische Polyolefine, Polysulfon, (Meth)acrylatpolymere und/oder Copolymere, Polyvinylalkohol, Polyvinylcarbazol, Vinylacetatcopolymere oder Polyvinylpyrrolidon.

Gegenstand der Erfindung ist weiterhin die Verwendung von feinteiligen anorganischen Partikeln, dispergiert in einem polymeren Binder, zur Herstellung von Zwischenschichten in elektrolumineszierenden Anordnungen.

Gegenstand der Erfindung sind weiterhin elektrolumineszierende Anordnungen, die eine oder mehrere, in der Regel ein oder zwei, der oben beschriebenen Zwischenschichten enthalten, sowie die Verwendung der elektrolumineszierenden Anordnung zur Herstellung von Leuchtanzeigen.

Der schematische Aufbau von LED ist beispielsweise wie folgt:

A) Kathode (z. B. Al, Ca, Mg) / Zwischenschicht mit Nanoteilchen / Elektrolumineszenz-Schicht (transparente Anode (In-Sn-Oxid) / transparentes Substrat (z. B. Glas oder Folie).

B) Kathode / Elektrolumineszenz-Schicht / Zwischenschicht mit Nanoteilchen / transparente Anode / transparentes Substrat.

C) Kathode / Zwischenschicht mit Nanoteilchen / Elektrolumineszenz-Schicht / Zwischenschicht mit Nanoteilchen / transparente Anode / transparentes Substrat.

Die Zwischenschichten sind folgendermaßen angeordnet

A) als Zwischenschicht zwischen der elektrolumineszierenden Schicht und der Kathode

oder

B) als Zwischenschicht zwischen der elektrolumineszierenden Schicht und der Anode

oder

C) als Zwischenschichten sowohl zwischen Kathode und elektrolumlneszierender Schicht als auch zwischen Anode und elektrolumineszierender Schicht.

Das System aus Nanoteilchen in polymeren Bindern läßt sich durch Spin-coating, Aufgießen und Rakeln großflächig als dünner Film als Zwischenschicht in polymeren Leuchtdioden aufbringen. Der Vorteil der kostenreduzierenden, großflächigen Herstellbarkeit polymerer Leuchtdioden bleibt dabei erhalten.

Die Eigenschaften der aus Polymeren aufgebauten polymeren LED (analog US-P-5 247 190) werden durch diese Zwischenschichten deutlich verbessert. So wird die Effizienz der Elektrolumineszenz wesentlich erhöht. Bei gleicher angelegter Spannung ist der durch die Anordnung fließende Gleichstrom deutlich niedriger, die Elektrolumineszenzintensität bleibt dabei aber gleich oder ist sogar erhöht.

Neben der Effizienzsteigerung zeichnen sich die erfindungsgemäßen Schichten durch eine erhöhte Langzeitstabilität aus. Eine Auskristallisation der Komponenten unter Betrieb, wie sie bei den organischen Systemen aus Monomeren in Bindern oder aufgedampften Monomeren auftritt, erfolgt in diesem System nicht. Gleichzeitig ist die elektrolumineszierende Anordnung stabiler gegen chemische Veränderungen wie beispielsweise Oxidation.

Aus Polymeren aufgebaute elektrolumineszierende Anordnungen mit den erfindungsgemäßen Zwischenschichten arbeiten bei niedrigen Gleichspannungen. Neben der einfachen und preiswerten Herstellung durch Aufrakeln der Schicht läßt sich die Lumineszenzfarbe durch Variation der chromophoren Bausteine steuern.

Die Filmdicke der Zwischenschicht sollte kleiner als 2 $\mu$m sein, typischerweise beträgt sie 10 bis 150 nm. So können auch bei niedrigen Spannungen hohe Feldstärken erreicht werden. Die erfindungsgemäße Zwischenschicht zeichnet sich durch eine homogene Schichtdicke aus, und die EL-Anordnung ist auch noch bei hohen Feldstärken von typischerweise >$10^6$ V/cm elektrisch durchschlagfest.

Geeignete anorganische Nanoteilchen mit einem Durchmesser <1 $\mu$m sind auf verschiedene Weise herstellbar:

- durch Fällungsreaktion (E. Matijevic, Chem. Mater. 5 (1993), 412-426), im Fall des $TiO_2$ beispielsweise durch Hydrolyse einer Titanylsulfatlösung und Peptisation des sulfatfrei gewaschenen Niederschlags in einbasiger Säure (EP-A-261 560), durch Hydrolyse von $TiCl_4$-Lösung (W. Bauer und G. Tomandl, Ceram. Int. 20 (1994), 189-93);

- nach dem Sol-Gel-Verfahren durch Hydrolyse von Alkoxiden, wie z.B. beschrieben in J. Livage, Mat. Sci. Forum 152-153 (1994), 43-45; G.W. Koebrugge et al., J. Mater. Chem. 3 (1993), 1095-1100; PCT-WO 93/05875 und PCT-WO 91/16719;

- nach dem CVR-Verfahren durch Umsetzung verdampfbarer Metall-Verbindungen (z.B. Alkoxide, Halogenide) mit überschüssigem Sauerstoff oder Wasserdampf bzw. Pyrrolyse in der Gasphase, siehe US-P-4 842 832 und K.Y. Kim et al., J. Chem. Engng. Jpn. 27 (1994), 657-61;

- durch Plasmasynthese, siehe Z. Chen. et al., Gongneng Cailiao 23 (1992), 83-7, 105 (Chem. Abstr. 119: 277086 c);

- durch Flammhydrolyse z.B. von $TiCl_4$; derartige Produkte sind auf dem Markt unter der Handelsbezeichnung Degussa P 25 erhältlich.

- durch Umsetzung von Titanylsulfatlösung mit unterschüssigem Alkali (siehe unten).

Besonders geeignet sind Nanoteilchen aus Titandioxid, die durch Umsetzung von Titanylsulfatlösung erhalten werden. Das Verfahren zur Herstellung des besonders geeigneten nanodispersen Titandioxids ist dadurch gekennzeichnet, daß

a) zu einer alkalisch reagierenden Flüssigkeit bei erhöhter Temperatur eine schwefelsaure Titanylsulfatlösung zugegeben wird, bis die so erhaltene Mischung sauer reagiert, also Schwefelsäure im Überschuß vorliegt,

b) die unter a) erhaltene Mischung abgekühlt wird,

c) anschließend eine einbasige Säure zu der nach b) erhaltenen Mischung zugegeben wird, wobei die unter a) gebildeten Titandioxidnanopartikel ausflokken,

d) der unter c) gebildete Flockungsniederschlag abfiltriert und mit der gleichen einbasigen Säure wie unter c) gewaschen wird.

Um das erfindungsgemäße Titandioxid-Sol zu erhalten, wird der nach Reaktionsschritt d) erhaltene Niederschlag in Wasser und/oder Alkoholen, die 1 bis 10 Kohlenstoffatome und eine oder mehrere Hydroxidgruppen im Molekül aufweisen, aufgenommen.

Die Herstellung des erfindungsgemäßen nanodispersen $TiO_2$ gelingt auch im Rahmen eines großtechnischen Prozesses, nämlich der $TiO_2$-Pigmentherstellung nach dem Sulfatverfahren, und ist damit sehr einfach und wirtschaftlich.

Der nach dem erfindungsgemäßen Verfahren erhaltene Filterrückstand (nach Schritt d)) kann anorganisch und/oder organisch nachbehandelt werden.

Als Edukt (schwefelsaure Titanylsulfatlösung) ist im Prinzip jede Schwefelsäure im Überschuß enthaltende Titanylsulfatlösung geeignet. Verunreinigungen von Metallen, die lösliche Sulfate und Chloride bilden, wie z.B. Eisen, Magnesium, Aluminium und Alkalimetalle stören beim Herstellungsprozeß im Prinzip nicht, es sei denn, die genannten Elemente wirken sich für den jeweiligen Anwendungszweck schon in Spuren nachteilig aus. Damit ist die Durchführung des erfindungsgemäßen Verfahrens im großtechnischen Maßstab möglich. Als Edukt kann z.B. Schwarzlösung eingesetzt werden, wie sie im Sulfatprozeß nach dem Aufschluß von Ilmenit und/oder Titanschlacke mit Schwefelsäure, Lösen des erhaltenen Aufschlußkuchens in Wasser und Klärfiltration anfällt.

Das Herstellungsverfahren ist jedoch nicht auf Schwarzlösung als Edukt beschränkt. Andere Verfahren zur Herstellung einer als Edukt geeigneten schwefelsauren Titanylsulfatlösung sind beispielsweise:

a) Auflösen/Aufschließen von Titandioxid und $TiO_2$-Hydraten, z.B. Orthotitansäure, Metatitansäure, in überschüssiger $H_2SO_4$;

b) Auflösen/Aufschließen von Alkali- und Magnesiumtitanaten, auch in wasserhaltiger Form, in überschüssiger $H_2SO_4$;

c) Umsetzung von $TiCl_4$ mit überschüssiger $H_2SO_4$ unter Bildung von $TiOSO_4$ und HCl, wie in DE-A 42 16 122 beschrieben.

Die Produkte, insbesondere aus a) und aus c) kommen als schwefelsaure Titanylsulfatlösungen bevorzugt dann zum Einsatz, wenn Spuren von Fremdmetallen (z.B. Eisen) im Produkt (nanodispersen Titandioxid) unerwünscht sind.

Für eine wirtschaftlich sinnvolle Arbeitsweise enthalten die erfindungsgemäß einzusetzenden schwefelsauren Titanylsulfatlösungen bevorzugt 100 bis 260, besonders bevorzugt 170 bis 230 g Titan/l, berechnet als $TiO_2$. Der Säureüberschuß beträgt bevorzugt 0,3 bis 4,0, besonders bevorzugt 0,5 bis 1,5 mol $H_2SO_4$ pro mol $TiOSO_4$.

Als alkalisch reagierende Flüssigkeiten werden vorzugsweise wäßrige Lösungen von Natrium-, Kaliumhydroxid oder Ammoniak eingesetzt; prinzipiell können auch Carbonate von Natrium, Kalium und Ammonium eingesetzt werden, die jedoch aufgrund der starken $CO_2$-Entwicklung weniger geeignet sind. Besonders bevorzugt ist Natronlauge, anhand derer die Verfahrensdurchführung näher erläutert wird.

Die Natriumhydroxidmenge ist so zu bemessen, daß das Natriumhydroxid im stöchiometrischen Unterschuß beispielsweise bezüglich der "freien Schwefelsäure" nach Reaktionsschritt a) vorliegt. Unter "freier Schwefelsäure" im Rahmen des Sulfatprozesses der $TiO_2$-Produktion versteht der Fachmann den Gesamtschwefelsäuregehalt abzüglich des in Form von Fremdmetallsulfaten (in erster Linie $FeSO_4$) gebundenen Anteils, d.h. die Summe aus $H_2SO_4$ und als $TiOSO_4$ gebundener Schwefelsäure; der letztgenannte Anteil liegt nach der Hydrolyse als $H_2SO_4$ vor.

Die Natronlaugemenge wird im stöchiometrischen Unterschuß bezüglich der beiden Reaktionen

$$H_2SO_4 + 2\ NaOH \rightarrow Na_2SO_4 + 2\ H_2O$$

$$TiOSO_4 + 2\ NaOH \rightarrow TiO_2 + Na_2SO_4 + H_2O$$

eingestellt, wobei der Unterschuß vorzugsweise so gewählt wird, daß der pH-Wert am Ende des Reaktionsschrittes a) Kleiner als 2 ist.

Bevorzugt wird als Natronlauge eine wäßrige Natriumhydroxidlösung verwendet, deren Konzentration vorzugsweise etwa 5 bis 10 Gew.-% NaOH beträgt.

Die Umsetzung der unterschüssigen Natronlauge mit der schwefelsauren Titanylsulfatlösung erfolgt bevorzugt dergestalt, daß die auf etwa 60 bis 100°C erwärmte Natronlauge vorgelegt wird und man in diese Lösung die schwefelsaure Titanylsulfatlösung einlaufen läßt.

Der Reaktionsschritt a) sollte bevorzugt unter intensivem Rühren und bei Temperaturen von 60 bis 100°C durchgeführt werden.

Der alkalische pH-Bereich in der Vorlage sollte möglichst rasch (in bevorzugt weniger als 5 Minuten) durchlaufen und verlassen werden.

Die Mischung sollte vorzugsweise nach dem Reaktionsschritt a) auf Temperaturen unterhalb 60°C abgeschreckt werden und dann gegebenenfalls 1/2 bis 2 Stunden bei dieser Temperatur unter Rühren gehalten werden.

Die so erhaltene Mischung ist mehr oder weniger getrübt (trübes Sol). Derartige Mischungen werden als sogenannte Hydrolysekeime im $TiO_2$-Sulfatprozeß eingesetzt. Als transparente Sole sind sie ungeeignet.

Nach der Abkühlung wird mittels einer einbasigen Säure ausgeflockt und durch Filtration der Flockungsniederschlag isoliert. Dabei handelt es sich um nanodisperses Titandioxid mit einer Teilchengröße zwischen 1 und 10 nm, mit weniger als 0,1 Gew.-% Kohlenstoff und einer Transparenz von mindestens 99 % (siehe unten).

Bevorzugt wird vor der Zugabe der einbasigen Säure geklärt. Dies kann in einfacher Weise durch Sedimentation, d.h. mindestens 12stündiges ruhiges Stehen und Dekantieren erfolgen. Es ist aber auch möglich, zu zentrifugieren oder zu filtrieren, falls erforderlich mit einer Filterhilfe.

Durch die Zugabe der einbasigen Mineralsäure werden die in Reaktionsschritt a) gebildeten Nanopartikel reversibel ausgeflockt. Die erhaltenen voluminösen Flocken sind aufgrund ihrer Größe (bevorzugt 1 bis 10 μm) gut zentrifugierbar und filtrierbar. Die bevorzugte einbasige Säure ist Salzsäure, anhand derer die weitere Verfahrensweise näher erläutert werden soll. Bei Einsatz anderer einbasiger Mineralsäuren ist entsprechend zu verfahren.

Bevorzugt sollte die HCl-End-Konzentration in der Mischung nicht Kleiner als 1 molar sein; bevorzugt wird sie auf 1 bis 6 molar, besonders bevorzugt auf 1 bis 4 molar eingestellt, um die Nanopartikel auszufällen.

Als Filtertücher werden solche aus säurefestem Material (beispielsweise Polypropylen) bevorzugt. Besonders geeignet sind die dem Fachmann bekannten säurefesten Filtertücher, die im Rahmen des Sulfatprozesses auch zur Isolierung von $TiO_2$-Hydrolysat verwendet werden, sowie Membranfilter auf der Basis von Cellulose, Celluloseethern oder -estern.

Der Niederschlag wird anschließend ausgewaschen, bevorzugt mit der gleichen einbasigen Säure, die auch zur Flockung verwendet wird. Im Fall von Salzsäure ist 3 bis 6 molare Salzsäure als Waschflüssigkeit besonders geeignet.

Die erhaltenen (salz-)sauren Niederschläge (Pasten) enthalten je nach Filteraggregat und Ausgangsmaterial 20 bis 40, typischerweise etwa 30 Gew.-% $TiO_2$, Rest Waschsäure und gegebenenfalls geringe Verunreinigungen.

Die Niederschläge liefern, in Wasser aufgenommen, "Lösungen" (Sole), die bis auf eine leichte Opaleszenz (Tyndall-Effekt) klar, transparent und farblos bzw. fast farblos sind. In diesen Solen liegt das $TiO_2$ vollständig als Nanopartikel vor, dessen Durchmesser zwischen 1 und 10 nm liegt.

Es gelingt auf diese Weise, stark saure, nahezu völlig transparente (wasserklare) Sole mit bis zu ca. 20 Gew.-% $TiO_2$ herzustellen. Die Transparenz der Sole liegt bei einer Konzentration von 5 Gew.-% $TiO_2$ über den gesamten sichtbaren Spektralbereich über 99 % (gemessen in 180°/d-Geometrie).

Durch Zugabe einbasiger Mineralsäuren, z.B. HCl, können die Nanopartikel wieder ausgeflockt, abfiltriert und gewaschen werden. Sie sind in dieser Form bei Aufbewahrung um 0°C wochenlang ohne Veränderung haltbar.

Ähnliche Sole sind auch in polaren organischen Lösungsmitteln, in erster Linie in ein- und mehrwertigen kurzkettigen Alkoholen, wie z.B. Ethanol und Butandiol(1,4), herstellbar. Die Alkohole weisen bevorzugt 1 bis 10 Kohlenstoffatome im Molekül auf.

Durch Abdampfen der Flüssigkeit und der anhaftenden Säure bei möglichst niedriger Temperatur im Vakuum oder über NaOH (Raumtemperatur, Gefriertrocknung) erhält man aus den Pasten glasartige Xerogele, die bei nicht zu weitgehender Abtrennung von $H_2O$ und HCl in Wasser Klar dispergierbar sind.

Durch Dialyse gegen verdünnte einbasige Mineralsäuren gelingt es, gegebenenfalls vorhandene Schwermetallionen abzureichern.

Bei Anwendungen, in denen Säureüberschüsse störend wirken, können die erfindungsgemäßen Teilchen in prinzipiell bekannter Weise im neutralen pH-Bereich stabilisiert werden, z.B. mit Acetylaceton (WO 93/05875) oder mit Hydroxycarbonsäuren (EP-A 518 175).

## Beispiel

Herstellung einer Zwischenschicht aus nanokristallinem $TiO_2$ in Polyvinylalkohol und einer elektrolumineszierenden Anordnung enthaltend diese Zwischenschicht.

A) ITO beschichtetes Glas (hergestellt von der Fa. Balzers) wird in 20 x 30 $mm^2$ große Substrate geschnitten und gereinigt. Dabei werden folgende Schritte sukzessive durchgeführt:

1. 15 Minuten mit destilliertem Wasser und z. B. Spülmittel (basisch, Falterol) im Ultraschallbad spülen,

2. 2 x 15 Minuten mit jeweils frischem destilliertem Wasser im Ultraschallbad spülen,

3. 15 Minuten mit Ethanol im Ultraschallbad spülen,

4. 2 x 15 Minuten mit jeweils frischem Aceton im Ultraschallbad spülen,

5. Trocknen mit fusselfreien Linsentüchern.

Das elektrolumineszierende Polymer Poly(2-methoxy,5-(2'-ethyl-hexoxy)-1,4-phenylene-vinylene), kurz MEH-PPV, wird wie beschrieben bei D. Braun et al., App. Phys. Lett. 58 (1991) 1892 hergestellt.

Eine 1 gew-%ige Lösung des elektrolumineszierenden Polymers MEH-PPV in Chloroform wird gefiltert (0,2 μm-Filter, Fa. Sartorius). Die gefilterte Lösung wird mit einer Lackschleuder bei 1000 U/min auf der ITO-Schicht verteilt. Die Dicke des getrockneten Films beträgt 105 nm. Die Rauhigkeit der Oberfläche beträgt 5 nm (Stylusprofilometer Alpha-Step 200 der Fa. Tencor Inst.).

B) Die verwendeten Nano-$TiO_2$-Partikel werden durch Fällung aus Titanylsulfatlösung mit Alkalilauge wie folgt hergestellt:

Herstellung des Nano-$TiO_2$ aus sogenannter Schwarzlösung:

In einem doppelwandigen, beheizbaren 6 l-Planschlifftopf mit mechanischem Rührer, Thermometer, Rückflußkühler und mit Bodenventil zum Ablassen des Produktes werden 1400 ml 7,5 gew.-%ige Natronlauge auf 85°C erwärmt. In einem 1 l-Dreihalskolben mit Rührer, Rückflußkühler, Heizpilz und Bodenablaßventil werden 804 ml einer nach dem Sulfatverfahren hergestellten $FeSO_4$-haltigen Schwarzlösung ($d_{60°C}$ = 1,566 g/ml; 13,83 Gew.-% $TiO_2$ entspricht 217 g/l; 28,39 Gew.-% freie $H_2SO_4$) auf 60°C erwärmt. Unter intensivem Rühren läßt man die Schwarzlösung innerhalb von gut 3 Minuten aus einer Glasdüse in die vorgelegte Natronlauge einlaufen, wobei sich vorübergehend ein dichter, dunkler Niederschlag bildet. Durch die Neutralisationswärme erhöht sich die Temperatur der Mischung auf 92°C. Nach etwa 5 minütigem Nachrühren ist die Mischung nur noch leicht getrübt. Anschließend wird sie in 20 Minuten unter weiterem Rühren auf 30°C abgekühlt.

Zu 244 ml einer so hergestellten Mischung werden innerhalb von 5 Minuten bei Raumtemperatur 244 ml halbkonzentrierter Salzsäure (20,6 Gew.-%, ca. 6,2 molar) getropft. Es bildet sich ein weißer Niederschlag. Nach 1stündigem Stehen zur Vervollständigung der Fällung wird der Niederschlag über ein Cellulosenitratfilter abgesaugt und portionsweise mit insgesamt 900 ml der obengenannten Salzsäure gewaschen.

Es werden 32,5 g einer weißen Paste mit 34,5 Gew.-% $TiO_2$ (entspricht 58 % der Theorie), 14,7 Gew.-% HCl, 2,7 Gew.-% $SO_4^{2-}$ und 170 ppm Fe erhalten.

10,8 g der Paste werden in 32,1 g destilliertem Wasser gelöst. Die "Lösung" enthält ca. 8,3 Gew.-% $TiO_2$ und 3,6 Gew.-% HCl und ist nahezu klar.

Die Nano-$TiO_2$-Teilchen haben einen mittels Ultrazentrifuge (Lösungsmittel: Wasser/HCl) bestimmten Durchmesser von 4,5 nm und enthalten zur Stabilisierung ca. 50 Gew.-% HCl, bezogen auf $TiO_2$.

Der verwendete Polyvinylalkohol ist Moviol 8-88 (Hoechst AG).

C) Herstellung einer elektrolumineszierenden Anordnung mit der erfindungsgemäßen Zwischenschicht.

Eine Lösung bestehend aus 1 Gewichtsteil 8 %iger Nanoteilchen-$TiO_2$-Lösung gemäß Beispiel B) in Wasser und 2 Gewichtsteilen aus 2,5 %iger Moviollösung in Wasser wird hergestellt.

Diese Lösung wird gefiltert (0,2 $\mu$m-Filter, Fa. Sartorius). Die gefilterte Lösung wird auf dem MEH-PPV-Film aufgebracht und mit der Lackschleuder bei 3000 U/min verteilt. Die getrocknete Gesamtschichtdicke des 2-Schichtaufbaus beträgt 159 nm. Die Rauhigkeit der Oberfläche beträgt 8 nm (Stylusprofilometer Alpha-Step 200 der Fa. Tencor Inst.).

Das so hergestellte Doppelschichtsystem wird anschließend mit Al-Elektroden bedampft. Dazu werden mit Hilfe einer Lochmaske isolierte Al-Punkte mit einem Durchmesser von 3 mm auf die $TiO_2$/Moviol-Oberfläche gedampft. Während des Aufdampfens herrscht in der Aufdampfapparatur (Leybold) ein Druck von unter $10^{-5}$ mbar.

Die ITO-Schicht und die Al-Elektrode werden über elektrische Zuführungen mit einer Spannungsquelle verbunden. Beim Erhöhen der Spannung fließt ein Strom durch die Doppelschichten. Ab einer Spannung von 5 Volt wird Elektrolumineszenz nachweisbar. Die Farbe der Elektrolumineszenz ist gelb-rot.

Die Elektrolumineszenzintensität der EL-Anordnung mit der $TiO_2$/Moviol-Zwischenschicht ist bei gleichen Strömen deutlich höher als im System ohne die $TiO_2$/Moviol-Zwischenschicht (Vergleich: Es wird wie in Beispiel C vorgegangen, jedoch wird die Zwischenschicht weggelassen). Die Leuchtdichten bei 20 V betragen in beiden EL-Anordnungen 10 cd/m$^2$. Mit der $TiO_2$/Moviol-Zwischenschicht fließt aber nur ein Strom von 0,5 mA, während der Strom ohne die $TiO_2$/Moviol-Zwischenschicht bei 20 V 30 mA beträgt. Besteht die Zwischenschicht nur aus Moviol, fließt kein Strom, und es wird keine Elektrolumineszenz nachgewiesen.

**Patentansprüche**

1.  Zwischenschicht in elektrolumineszierenden Anordnungen, enthaltend feinteilige anorganische Partikel (Nanoteilchen), die in einem polymeren Binder dispergiert sind.

2.  Zwischenschicht gemäß Anspruch 1, enthaltend Metalloxide oder Halbleiterverbindungen aus der III. und V. Hauptgruppe des Periodensystems (III-V-Halbleiter) oder Halbleiterverbindungen aus der II. und VI. Hauptgruppe des Periodensystems (II-VI-Halbleiter) als anorganische Partikel.

3.  Zwischenschicht gemäß Anspruch 2, enthaltend $TiO_2$, $SnO_2$, ZnO, $WO_3$, $Al_2O_3$, $Fe_2O_3$, GaP, AlN, ZnSe, CdSe oder CdS als anorganische Partikel.

4.  Zwischenschicht gemäß Anspruch 1, enthaltend Titandioxid als anorganische Partikel.

5.  Zwischenschicht gemäß Anspruch 1, wobei der Gewichtsanteil der anorganischen Partikel im polymeren Binder 0,1 bis 90 Gew.-% (bezogen auf die gesamte Zwischenschicht) beträgt.

6.  Zwischenschicht gemäß Anspruch 1, dadurch gekennzeichnet, daß die anorganischen Partikel aus halbleitendem Material einen Bandabstand von mindestens 1 eV aufweisen.

7. Verwendung von feinteiligen anorganischen Partikeln, dispergiert in einem polymeren Binder, zur Herstellung von Zwischenschichten in elektrolumineszierenden Anordnungen.

8. Elektrolumineszierende Anordnung enthaltend eine oder mehrere Zwischenschichten gemäß Anspruch 1.

9. Verwendung von elektrolumineszierenden Anordnungen gemäß Anspruch 8 zur Herstellung von Leuchtanzeigen.